# EUROPÄISCHE PATENTANMELDUNG

(11) **EP 0 841 755 A1**
(43) Veröffentlichungstag der Anmeldung: **13.05.1998**
(21) Anmeldenummer: 96117924.9
(22) Anmeldetag: 08.11.1996
(51) Int. Cl.: H04B 1/24, H03F 3/60

(54) **Stromsparender und empfindlicher Hochfrequenzempfänger unbedingter Stabilität**

(71) Anmelder: DELTEC Nachrichtentechnik GmbH, 30926 Seelze (DE)
(72) Erfinder: Piechaczek, Dieter, 30926 Seelze (DE)

(57) **Zusammenfassung**

Durch die weiter steigenden Ansprüche an die Dichte der Bauteile und an den zuverlässigen Betrieb sowie das Bestreben, die Stromaufnahme besonders für mobile Geräte weiter zu verringern, stoßen bisher angewandte HF-Empfängerkonzepte sowohl auf der technischen wie auf der Seite der Kosten an ihre Grenzen.

Diese liegen z. B. in der Rückwirkungsgefahr zwischen einzelnen HF-Verstärkerstufen durch kritische Leiterbahnführung, Nebenaussendungsprodukte der Mischstufe, dem manuellen Abgleichen in der Produktion und der relativ hohen Stromaufnahme.

Zweckmäßige Aufgabe der Erfindung ist es, beim Empfang schwacher HF-Signale die Rückwirkungsgefahr zwischen den einzelnen, hoch verstärkenden HF-Stufen zu beseitigen, um unbedingte Stabilität zu erreichen, ferner Abgleichpunkte des HF-Empfängers in der Produktion zu vermeiden, um den Schaltungs- und Kostenaufwand und die Stromaufnahme entscheidend zu verringern.

## Beschreibung

Die Erfindung betrifft HF-Verstärker in Funkempfängern im Zusammenhang mit der Verstärkung sehr schwacher HF-Signale und ist insbesondere geeignet für mobile Low-Power-Anwendungen, z. B. in der Telemetrie, bei Alarmund Sicherheitssystemen, bei Rundfunk- und Fernsehgeräten sowie bei drahtlosen Kommunikationssystemen, die bei einem netzunabhängigem Einsatz für eine extrem niedrige Stromaufnahme konzipiert sind, um z. B. mit 3-Volt-Lithium-Batterien betrieben zu werden.

HF-Empfänger existieren seit ca. 100 Jahren. Der erste einfache Detektorempfänger bestand neben dem abstimmbaren Schwingkreis aus einer Demodulatordiode und dem Kopfhörer als Tiefpaßfilter und ließ nur den schwachen Empfang weniger Stationen zu. Höhere Empfindlichkeit wurde später mit einem zusätzlichen HF-Vorverstärker erreicht, stabile Verstärkung war jedoch schwierig.

Der Diodendetektorempfänger wurde vom Pendelfrequenzempfänger abgelöst. Die Empfindlichkeit erhöhte sich damit und auch der Lautsprecherbetrieb war durch hinzugefügte NF-Verstärkerstufen möglich. Die Senderabstimmung war jedoch ein Balanceakt mit ständigem manuellen Nachstimmen. Ferner wurden Eigenstörungen produziert, die über die eigene Empfangsantenne wieder abgestrahlt wurden und somit andere Empfänger störten.

Die nächste Empfängergeneration mit dem Überlagerungsprinzip war ein deutlicher Qualitätssprung beim Funk-Empfang. Der Superheterodyne-Empfänger, kurz Superhet genannt, verringert die Problematik der Instabilität.

Dadurch kann die Empfindlichkeit weiter gesteigert werden, da die HF-Verstärkung zwischen einem Vor- und einem Zwischenfrequenzverstärker aufgeteilt wird. Da die HF- und ZF-Ebenen frequenzmäßig ungleich sind, führen Rückwirkungen des ZF- auf den HF-Verstärker weniger leicht zu Instabilitäten. Wird die Anzahl der frequenzumsetzenden Stufen weiter erhöht, verbessert sich nicht nur die Stabilität sondern auch die Unterdrückung von unerwünschten Signalen nimmt durch die kaskadierten ZF-Filter weiter zu.

Die wesentlichen Nachteile des Superhetprinzips sind ein Oszillator höchster Stabilität, HF-Nebenprodukte der Mischerstufe, die zu Eigen- und Fremdstörungen führen, ein kritisches Leiterplattenlayout wegen der Gefahr der Rückwirkung zwischen einzelnen Stufen durch benachbarte und HF-führende Leiterbahnen, komplexe Schaltung, Abgleichpunkte, höhere Kosten und relativ hohe Stromaufnahme der HF-Verstärkerstufen.

Es stellt sich die Aufgabe eines unbedingt stabilen HF-Empfängers, bei dem sich der Schaltungsaufwand und die Stromaufnahme entscheidend verringert, kritisches Leiterbahnlayout bei zunehmender Bauteiledichte verhindert und auf Abgleichpunkte verzichtet wird, was durch die vorliegende Erfindung gelöst wird.

Die Erfindung zeichnet sich dadurch aus, daß das beim Superhet-Empfänger bestehende Prinzip der Frequenzverschiedenheit einzelner HF-Stufen, verbunden mit der Problematik von Rückwirkungen, verlassen wird und daß stattdessen das Prinzip der zeitlichen Verschiedenheit der einzelnen HF-Verstärkerstufen Anwendung findet, wobei diese durch eine CPU-kontrollierte Zeitsteuerung mit definiertem Ablauf ein- und ausgeschaltet werden.

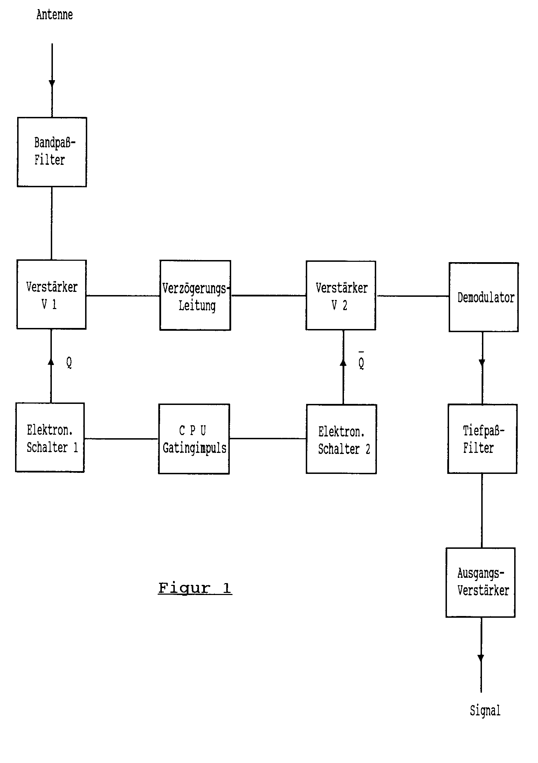

Der HF-Empfänger ist als Blockschaltbild in Figur 1 (sh. Anlage Zeichnung) dargestellt. Er besteht aus den beiden HF-Verstärkerstufen V1 und V2, deren Signalweg durch eine Verzögerungsleitung voneinander getrennt ist. Zusätzlich werden die HF-Verstärkerstufen V1 und V2 durch die elektronischen Schalter 1 und Schalter 2 aktiviert und deaktiviert und damit ein- und ausgeschaltet. Damit diese sehr schnellen Schaltvorgänge kontrolliert ablaufen, werden beide elektronischen Schalter durch die von einer CPU (Control Processing Unit) generierten Gatingimpulse definiert angesteuert, um einen zeitkontrollierten Ablauf zu gewährleisten.

Anm.: es existieren CPU-Bausteine, die Stromaufnahmen aufweisen, welche mehrere Größenordnungen niedriger liegen als die einzelner HF-Verstärkerstufen.

Wesentlich ist folgender Vorgang: liegt ein HF-Signal am Eingang der HF-Verstärkerstufe V1 an, schaltet die CPU über den elektronischen Schalter 1 den HF-Verstärker V1 ein, während der HF-Verstärker V2 ausgeschaltet ist. Mit anderen Worten, die zweite HF-Verstärkerstufe arbeitet nicht, wenn die erste aktiv ist. Dadurch werden Rückwirkungen durch Strahlung oder andere unerwünschte Verkopplungen zwischen den einzelnen HF-Verstärkerstufen verhindert.

Das durch die erste HF-Verstärkerstufe V1 verstärkte HF-Signal gelangt auf eine Verzögerungsleitung, deren Ausgang auf den Eingang der Verstärkerstufe V2 führt. Spätestens zu dem Zeitpunkt, an dem das weiter zu verstärkende HF-Signal den Eingang des Verstärkers V2 erreicht, wird diese von der CPU über den Schalter 1 eingeschaltet, und gleichzeitig wird der Verstärker V1 durch die CPU über den Schalter 2 abgeschaltet.

Mit anderen Worten, die erste HF-Verstärkerstufe V1 arbeitet nicht und ist abgeschaltet, wenn die zweite HF-Verstärkerstufe V2 aktiviert ist und umgekehrt. Die Wirkung der Verzögerungsleitung besteht darin, daß die HF-Verstärkerstufe V1 spätestens dann von der CPU deaktiviert wird, wenn das HF-Signal den Eingang des HF-Verstärkers V2 erreicht hat.

Folgerichtig wird jede Rückwirkung des zweiten HF-Verstärkers V2 auf die erste HF-Verstärkerstufe V1 ausgeschlossen. Die Verzögerungsleitung verlangsamt quasi den Signalweg zwischen den beiden HF-Verstärkerstufen, wobei die quantitative Größe der Verzögerungszeit der Verzögerungsleitung durch die Parameter des modulierten HF-Signals bestimmt wird.

Es kommt bei der Erfindung entscheidend darauf an, daß die beiden HF-Verstärker V1 und V2 in keinem Fall gleichzeitig aktiviert sind.

Die Erfindung zeichnet sich dadurch aus, daß ein HF-Empfang mit hoher HF-Verstärkung möglich ist, da Rückwirkungen einer HF-Verstärkerstufe auf eine vorherige nicht zur Instabilität führen kann.

Folgerichtig arbeitet ein Hochfrequenzempfänger mit mindestens zwei HF-Verstärkerstufen bei vorgegebener Signalfrequenz und einer in der beschriebenen Weise aktivierten Stufe und bei dem die andere(n) Stufe(n) deaktiviert ist (sind) unbedingt stabil, ohne z. B. zur Oszillation zu neigen.

Nachdem das weiter verstärkte HF-Signal den Verstärker V2 verlassen hat, gelangt es zur nächsten Stufe und wird demoduliert.

Das der Demodulatorstufe nachgeschaltete Tiefpaßfilter beseitigt die Gatingimpulse der CPU bzw. der beiden elektronischen Schalter sowie Reste des HF-Trägers. Das Ausgangssignal des Tiefpaßfilters entspricht dem senderseitig aufmodulierten Analog- bzw. Digitalsignal und wird von dem der Demodulatorstufe folgenden Ausgangsverstärker weiter verstärkt.

Die Verstärkung des sequentiellen HF-Verstärkers, der aus der HF-Verstärkerstufe V1, der Verzögerungsleitung und der HF-Verstärkerstufe V2 besteht, kann für AM-Signale zusätzlich über eine der hinreichend bekannten automatischen Regelungsvarianten kontrolliert werden.

Es ist zu erkennen, daß der alternierende Betrieb der beiden HF-Verstärker eine Art Abtastung des Eingangssignals darstellt. Bei einer niedrigen Abtastrate wird eine große Anzahl von Modulationszyklen pro Abtastung und bei einer hohen Abtastrate wird eine große Anzahl von Abtastungen pro Modulationszyklus erreicht.

Es sind mit der sequentiellen Verstärkeranordnung noch diverse andere Anwendungen möglich. So eignet sich die Schaltung z. B. auch für den Empfang von FSK- und alle sonstigen Arten von digitalen Signalen, alle Arten von analogen Signalen und alle sonstigen Signalarten, die sehr hoch verstärkt werden müssen. Die Erfindung wurde in Figur 1 an lediglich einem Beispiel zur Ausführung beschrieben, jedoch soll sie sich nicht nur darauf beschränken. Im Gegenteil, es sollen alle möglichen Alternativen, Entsprechungen und Modifizierungen ihre Berücksichtigung finden, wie sie in den nachfolgenden Patentansprüchen definiert sind.

## Patentansprüche

1. Stromsparender und empfindlicher Hochfrequenzempfänger unbedingter Stabilität mit HF-Verstärkerstufen zum Empfang modulierter HF-Signale, mit einem abgestimmten Bandpaßfilter nach dem Antenneneingang, um ein gewünschtes HF-Signal zu selektieren, mit einem sequentiellen HF-Verstärker, eingangsseitig gekoppelt mit dem abgestimmten Bandpaßfilter, um das gewünschte und selektierte HF-Signal zu verstärken, mit mindestens zwei sequentiellen HF-Verstärkerstufen, die über eine Verzögerungsleitung miteinander gekoppelt sind, mit mindestens einer Verzögerungsleitung, deren Laufzeit von den Parametern des modulierten HF-Signals bestimmt wird, mit einer CPU (Control Processing Unit) für eine definierte zeitkritische Steuerung für die Aktivierung und Deaktivierung der mindestens zwei sequentiellen HF-Verstärkerstufen, mit mindestens zwei von der CPU angesteuerten elektronischen Schaltern zur Aktivierung und Deaktivierung der mind. zwei sequentiellen HF-Verstärkerstufen, dadurch gekennzeichnet, daß die CPU Gatingimpulse generiert, um über die mind. zwei elektronischen Schalter die mindestens zwei sequentiellen HF-Verstärkerstufen zur Vermeidung von Instabilitäten definiert ein- und auszuschalten, wobei jederzeit immer nur eine HF-Verstärkerstufe eingeschaltet ist, während die andere(n) HF-Verstärkerstufe(n) abgeschaltet ist (sind), um die maximale und dennoch unbedingt stabile Verstärkung jeder der mind. zwei sequentiellen HF-Verstärkerstufen zu erreichen, um eine unerwünschte Rückwirkung zu der(n) vorherigen HF-Verstärkerstufe(n) zu verhindern, mit einer der letzten sequentiellen HF-Verstärkerstufe folgenden Stufe zur Demodulation des HF-Signals, mit einem der Demodulatorstufe folgenden Tiefpaßfilter zur Unterdrückung unerwünschter Signale und mit einem Ausgangsverstärker zur Verstärkung des demodulierten Signals.

2. HF-Empfänger nach Anspruch 1, bei dem das demodulierte Ausgangssignal ein digitales Datensignal ist.

3. HF-Empfänger nach Anspruch 1, bei dem das demodulierte Ausgangssignal ein analoges Datensignal ist.

4. HF-Empfänger nach Anspruch 1, bei dem das digitale Datensignal ein NF-Signal ist.

5. HF-Empfänger nach Anspruch 1, bei dem das digitale Datensignal ein Videosignal ist.

6. HF-Empfänger nach Anspruch 1, bei dem das analoge Datensignal ein NF-Signal ist.

7. HF-Empfänger nach Anspruch 1, bei dem das analoge Datensignal ein Videosignal ist.

8. HF-Empfänger nach Anspruch 1, bei dem die CPU durch einen Mikrocontroller bzw. -prozessor realisiert ist.

9. HF-Empfänger nach Anspruch 1, bei dem die CPU durch einen Timer-Schaltkreis realisiert ist.

10. HF-Empfänger nach Anspruch 1, bei dem die CPU durch mind. zwei zu einem Ring geschaltete Multivibratoren realisiert ist.
